# EUROPEAN PATENT APPLICATION

(11) **EP 4 678 698 A1**
(43) Date of publication of application: **14.01.2026**
(21) Application number: 24766752.0
(22) Date of filing: 07.02.2024
(51) Int. Cl.: C08L 83/07, C08J 3/20, C08K 3/013, C08K 3/22, C08K 3/28, C08K 5/549, C08L 83/05, C08L 83/06, H01L 23/373

(54) **SILICONE COMPOSITION**

(30) Priority: 06.03.2023 JP 2023033569
(71) Applicant: SHIN-ETSU CHEMICAL CO., LTD., Tokyo 1000005 (JP)
(72) Inventor: TOYA, Wataru, Annaka-shi, Gunma 379-0224 (JP)
(74) Representative: Mewburn Ellis LLP
(86) International application number: PCT/JP2024/004121
(87) International publication number: WO 2024/185377

(57) **Abstract**

As a silicone composition that can provide a silicone grease having a high thermal conductivity and excellent adhesiveness as compared to conventional silicone greases, provided is a silicone composition comprising: (A) an organopolysiloxane having at least two aliphatic unsaturated hydrocarbon groups per molecule and having a kinematic viscosity of 60-100,000 mm²/s at 25°C; (B) a hydrolyzable organopolysiloxane represented by general formula (1); (C) at least one thermally conductive filler selected from the group consisting of metal oxides or metal nitrides; (D) an organohydrogen polysiloxane represented by general formula (2); (E) an organohydrogen polysiloxane represented by general formula (3); (F) a hydrolyzable organopolysiloxane represented by general formula (4); (G) a platinum group metal catalyst; and (H) a reaction control agent.

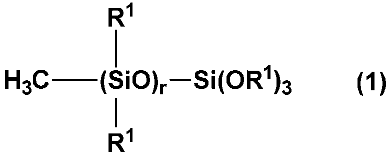

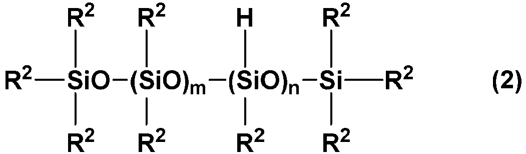

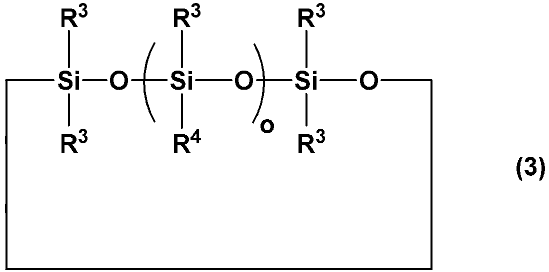

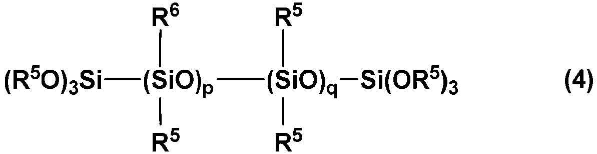

## Description

### TECHNICAL FIELD

This invention relates to a silicone composition. Specifically, this invention relates to a silicone composition which provides a silicone grease having a high thermal conductivity, the silicone composition capable of providing a grease which exhibits good adhesiveness even when a large amount of heat conductive filler is contained.

### BACKGROUND ART

Electronic devices such as LSIs and IC chips are widely known to generate heat during service, causing decrease in performance, and thus various heat dissipation techniques are employed as a solution. In general, a cooling member is disposed near a heat generating portion in close contact so that the heat is efficiently removed through the cooling member, thereby dissipating heat. If a gap is left between the heat generating member and the cooling member, air, which has poor thermal conductivity, is interposed and thus the thermal conductivity decreases, impeding sufficient reduction in temperature of the heat generating member. In order to prevent such a phenomenon, a heat dissipating material having a high thermal conductivity and a property of following the surfaces of the members, such as a heat dissipating grease or a heat dissipating sheet, is employed for the purpose of preventing interposition of air.

Some heat dissipating greases have an adhesion performance for causing a semiconductor chip and a heat spreader to solidly adhere to each other. In the case where the adhesion between the semiconductor chip and the heat spreader through the grease is insufficient, the heat dissipation ability may be inadequately exerted, causing considerable decrease in performance. It is therefore important to cause the semiconductor chip and the heat spreader to solidly adhere to each other through the grease. However, the improvement in thermal conductivity of the heat dissipating grease also necessitates filling the heat conductive filler in a large amount. The heat conductive filler filled in the grease in a large amount gives rise to a problem of decrease in adhesiveness of a resulting cured product. It is widely known that the decrease in adhesiveness makes the cured product unable to follow the strain of the semiconductor chip due to the heat history including heat generation and cooling, causing peeling, and in the worst case, the semiconductor chip may be broken.

Described in Patent Document 1 is a thermally conductive silicone grease composition containing as essential components: an alkenyl-containing organopolysiloxane; a heat conductive filler; an organohydrogenpolysiloxane; an organohydrogenpolysiloxane having at least one of an alkoxysilyl group or an epoxy group; and a platinum base catalyst. However, the thermal conductivity was not more than 2.0 W/mK in any Example, which is insufficient.

Described in Patent Document 2 is a thermally conductive silicone grease composition containing as essential components: an alkenyl-containing organopolysiloxane; a hydrolyzable methylpolysiloxane; a heat conductive filler, an organohydrogenpolysiloxane; a bonding aid having a triazine ring and an alkenyl group; and a platinum base catalyst. However, the thermal conductivity was not more than 3.0 W/mK in any Example, which is insufficient. Described in Patent Document 3 is a thermally conductive silicone composition containing a silicone resin having no aliphatic unsaturated hydrocarbon group, the composition capable of providing a heat dissipating grease having a high adhesive force. However, the thermal conductivity was not more than 4.0 W/mK in any Example, which is insufficient.

In recent years, high-grade semiconductor devices have generated increasingly large amounts of heat during their operation. Problems with conventional silicone greases are that their thermal conductivity is insufficient, and that while their thermal conductivity may be high, their adhesiveness is low.

### PRIOR ART DOCUMENTS

### PATENT DOCUMENTS

Patent Document 1: JP-A 2012-067153
Patent Document 2: JP-A 2012-102283
Patent Document 3: JP-A 2016-053140

### SUMMARY OF INVENTION

### TECHNICAL PROBLEM

An object of the invention, which has been made under the above-mentioned circumstances, is to provide a silicone composition which can provide a silicone grease having a high thermal conductivity and good adhesiveness as compared to conventional silicone greases.

### SOLUTION TO PROBLEM

Making extensive investigations to attain the above object, the inventor has found that a silicone composition containing: an aliphatic unsaturated hydrocarbon group-containing organopolysiloxane; an organopolysiloxane having a hydrolyzable group; a heat conductive filler; an organohydrogenpolysiloxane having a specific structure; and a platinum group metal catalyst provides a silicone grease having good adhesiveness even when a large amount of heat conductive filler is contained. The invention is predicated on this finding.

Accordingly, the invention provides a silicone composition as defined below.
1. A silicone composition comprising components (A) to (D):
   (A) an organopolysiloxane having at least two aliphatic unsaturated hydrocarbon groups per molecule and a kinematic viscosity at 25°C of 60 to 100,000 mm²/s in an amount of 100 parts by weight;
   (B) a hydrolyzable organopolysiloxane represented by the general formula (1) in an amount of 100 to 600 parts by weight: 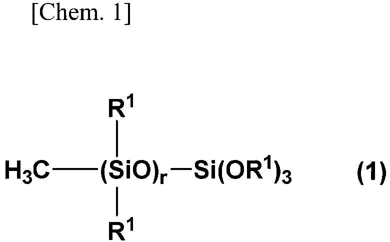 wherein R¹ is each independently a C₁-C₆ alkyl group and r is an integer of 5 to 100;
   (C) at least one heat conductive filler selected from the group consisting of metal oxides and metal nitrides in an amount of 4,001 to 12,000 parts by weight;
   (D) an organohydrogenpolysiloxane represented by the general formula (2) in an amount of 1.0 to 8.0 parts by weight: 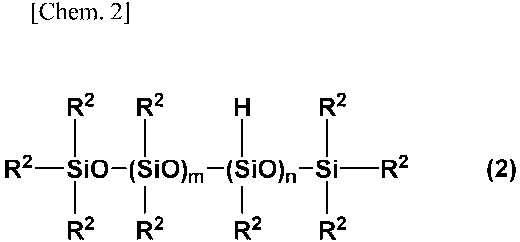 wherein n and m are each a number larger than 0 satisfying 5.0 ≤ n + m ≤ 100 and n/(n + m) ≤ 0.5, and R² is each independently a C₁-C₆ alkyl group;
   (E) an organohydrogenpolysiloxane represented by the general formula (3) in an amount of 1.0 to 7.0 parts by weight: 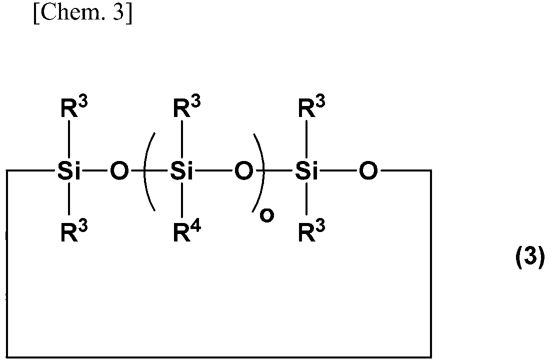 wherein o is an integer of 1 to 8; R³ is each independently a hydrogen atom, a C₁-C₆ alkyl group, or R⁴, provided that two or three groups out of the groups represented by R³ are hydrogen atoms; and R⁴ is a group selected from the group consisting of an epoxy group, an acryloyl group, a methacryloyl group, an ether group, and a trialkoxysilyl group, which is bonded to a silicon atom via a carbon atom or an oxygen atom;
   (F) a hydrolyzable organopolysiloxane represented by the general formula (4) in an amount of 1 to 30 parts by weight: 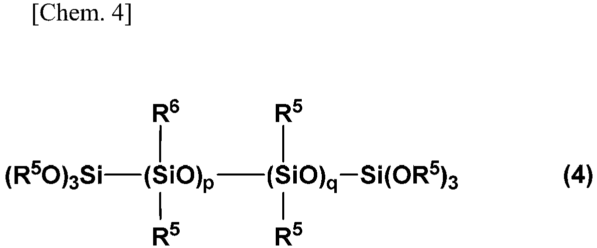 wherein p and q are each a number larger than or equal to 1.0 satisfying 5.0 ≤ p + q ≤ 100, R⁵ is each independently a C₁-C₆ alkyl group, and R⁶ is a C₂-C₆ alkenyl group;
   (G) a platinum group metal catalyst in a catalytic amount; and
   (H) a reaction inhibitor in an amount of 0.05 to 5.0 parts by weight.
2. The silicone composition of 1, wherein component (C) contains components (C-1) to (C-3):
   (C-1) aluminum nitride particles that have an average particle size of 10 µm or more and less than 30 µm and yield a residue in an amount of less than 1.0% by weight after being sieved through a 200-mesh wire gauze;
   (C-2) a metal oxide or a metal nitride having an average particle size of 1 µm or more and less than 10 µm; and
   (C-3) a metal oxide or a metal nitride having an average particle size of 0.1 µm or more and less than 1 µm.
3. The silicone composition of 1 or 2, wherein a cured product of the silicone composition has a thermal conductivity of 4.0 W/m·K or more.
4. A semiconductor device comprising:
   a cured product of a silicone composition interposed between a heat generating member and a cooling member,
   wherein a layer of the cured product is composed of a cured product of the silicone composition of any one of 1 to 3 and has a thickness of 100 µm or less.
5. A method of preparing the silicone composition of 2, the method comprising:
   a step of mixing components (C-1) to (C-3) with component (A) and component (B) in advance.

### ADVANTAGEOUS EFFECTS OF INVENTION

The silicone composition of the invention has good adhesiveness even when a large amount of heat conductive filler is contained, and accordingly, a silicone grease having a high thermal conductivity and good adhesiveness can be provided.

### DESCRIPTION OF EMBODIMENTS

Now the invention is described in detail.

### [Component (A)]

Component (A) is an organopolysiloxane having at least two aliphatic unsaturated hydrocarbon groups per molecule and a kinematic viscosity at 25°C of 60 to 100,000 mm²/s. The aliphatic unsaturated hydrocarbon group is preferably a C₂-C₈ monovalent hydrocarbon group having an aliphatic unsaturated bond, more preferably a C₂-C₆ monovalent hydrocarbon group having an aliphatic unsaturated bond, still more preferably an alkenyl group.

Examples of the aliphatic unsaturated bond include alkenyl groups such as vinyl, allyl, propenyl, isopropenyl, butenyl, hexenyl, cyclohexenyl, and octenyl. A vinyl group is particularly preferred. The aliphatic unsaturated hydrocarbon groups may be bonded to silicon atoms at terminal positions of the molecular chain, silicon atoms at non-terminal positions of the molecular chain, or both of them.

The organopolysiloxane has a kinematic viscosity at 25°C of 60 to 100,000 mm²/s, preferably 100 to 30,000 mm²/s. If the kinematic viscosity is less than 60 mm²/s, the silicone composition may have a low physical quality, and if the kinematic viscosity is more than 100,000 mm²/s, the silicone composition may have poor spreadability. The kinematic viscosity herein is measured at 25°C by an Ubbelohde-type Ostwald viscometer. The molecular structure of the organopolysiloxane is not particularly limited as long as the organopolysiloxane has the above property, and may be linear, branched, or partially-branched or partially-cyclic linear, or the like.

In particular, the organopolysiloxane preferably has a linear structure which has a backbone composed of repeating diorganosiloxane units and is capped with triorganosiloxy groups at both ends of the molecular chain. The organopolysiloxane having the linear structure may partially have a branched structure or a cyclic structure. The organopolysiloxane may be used alone or in admixture of two or more.

An organic group other than the aliphatic unsaturated hydrocarbon groups bonded to silicon atoms of the organopolysiloxane is preferably a C₁-C₁₈ unsubstituted or substituted monovalent hydrocarbon group, more preferably a C₁-C₁₀ unsubstituted or substituted monovalent hydrocarbon group, still more preferably a C₁-C₈ unsubstituted or substituted monovalent hydrocarbon group.

Examples of the unsubstituted or substituted monovalent hydrocarbon group include alkyl groups such as methyl, ethyl, propyl, isopropyl, butyl, isobutyl, tert-butyl, pentyl, neopentyl, hexyl, cyclohexyl, octyl, nonyl, and decyl; aryl groups such as phenyl, tolyl, xylyl, and naphthyl; aralkyl groups such as benzyl, phenylethyl and phenylpropyl; and the foregoing groups in which some or all of the hydrogen atoms are substituted by halogen atoms, e.g., fluorine, bromine, and chlorine, cyano groups, or the like, such as chloromethyl, chloropropyl, bromoethyl, trifluoropropyl, and cyanoethyl. A methyl group is particularly preferred.

### [Component (B)]

Component (B) is a hydrolyzable organopolysiloxane represented by the general formula (1). 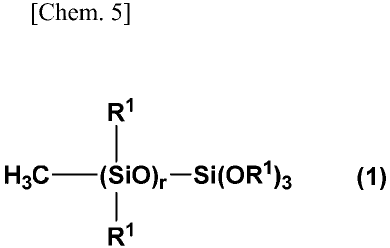 (wherein R¹ is each independently a C₁-C₆ alkyl group, and r is an integer of 5 to 100.)

R¹ in the above formula is a C₁-C₆ alkyl group, and examples thereof include a methyl group, an ethyl group, a propyl group, an isopropyl group, a butyl group, a sec-butyl group, a tert-butyl group, a pentyl group, a hexyl group, and the like. A methyl group, an ethyl group, a propyl group, an isopropyl group, and a butyl group are preferred, and a methyl group is more preferred.

r in the above formula is an integer of 5 to 100, preferably an integer of 10 to 60. If the value of r is below the lower limit, serious oil bleeding derived from the silicone composition may be caused, degrading reliability. If the value of r exceeds the upper limit, wettability relative to a filler may be insufficient.

The amount of component (B) is 100 to 600 parts by weight, preferably 100 to 300 parts by weight, still more preferably 200 to 300 parts by weight, per 100 parts by weight of component (A). If the amount of component (B) is below the lower limit, wettability may be insufficient. If the amount of component (B) exceeds the upper limit, considerable oil bleeding from the composition may be caused, lowering the adhesive force.

### [Component (C)]

Component (C) is at least one heat conductive filler selected from the group consisting of metal oxides and metal nitrides. Examples of the component (C) include aluminum nitride powder, aluminum oxide powder, zinc oxide powder, and magnesium oxide powder. Component (C) may be used alone or in admixture of two or more, and is preferably one or more selected from the group consisting of aluminum nitride powder, aluminum oxide powder, and zinc oxide powder. Furthermore, component (C) preferably contains the following components (C-1) to (C-3).
(C-1) Aluminum nitride having an average particle size of 10 µm or more and less than 30 µm
(C-2) Aluminum nitride or aluminum oxide having an average particle size of 1 µm or more and less than 10 µm
(C-3) Zinc oxide, aluminum nitride, or aluminum oxide having an average particle size of 0.1 µm or more and less than 1 µm

When component (C) is composed of a combination of components (C-1) to (C-3), the heat conductive filler can be more heavily packed, and the thermal conductivity of the resulting composition can be increased.

Component (C-1) is aluminum nitride having an average particle size of 10 µm or more and less than 30 µm, preferably aluminum nitride having an average particle size of 15 µm or more and 25 µm or less. When the average particle size falls within the above range, the high thermal conductivity as well as the stability can be achieved. In addition, component (C-1) yields a residue in an amount of preferably less than 1.0% by weight, more preferably less than 0.5% by weight, still more preferably 0.1% by weight, after being sieved through a 200-mesh wire gauze. Furthermore, component (C-1) yields a residue in an amount of further preferably less than 1.0% by weight, particularly preferably less than 0.5% by weight, most preferably 0.1% by weight, after being sieved through a 325-mesh wire gauze. Note that the 200-mesh wire gauze and 325-mesh wire gauze as used herein are wire gauzes specified in JIS Z 8801. When such component (C-1) that yields a residue in an amount of less than 1.0% by weight after being sieved through the 200-mesh wire gauze is employed, a coating film of the composition interposed between a heat generating member and a cooling member in a semiconductor device can have a sufficiently thin thickness.

Examples of the shape of component (C-1) include a crushed shape, a polyhedral shape, a round shape, and a true spherical shape, and a round shape is preferred. As used herein, the "average particle size" refers to a particle diameter at 50% accumulation in the volume basis particle size distribution as measured by the laser diffraction/scattering method. For the measurement by the laser diffraction/scattering method, for example, a particle size analyzer Microtrac MT3300EX (Nikkiso Co., Ltd.) may be used. Furthermore, component (C-2) and component (C-3) having a particle size different from that of component (C-1) is preferably contained, for the purpose of increasing fillability, reducing the viscosity of the composition, and preventing settling of the filler. The three-component system of components (C-1) to (C-3) leads to further reduction in viscosity of the composition, and improvement in adhesive force thereof after curing, as compared to the two-component system of component (C-1) and component (C-2).

The average particle size of component (C-2) is preferably 1 to 10 µm, more preferably 2 to 8 µm, still more preferably 3 to 7 µm. An average particle size of 1 to 10 µm contributes to provide a uniform composition after mixing of component (C-1), component (C-2), and component (C-3) with component (A) and component (B), further reduce the viscosity of the composition, and improve the adhesive force thereof after curing.

The average particle size of component (C-3) is preferably 0.1 to 1 µm. If component (C-3) has a size of 1 µm or more, the resulting silicone composition may have a high viscosity, or poor spreadability.

The amount of component (C) is 4,001 to 12,000 parts by weight, preferably 5,000 to 12,000 parts by weight, per 100 parts by weight of component (A). If the amount of the filler is less than 4,001 parts by weight, the resulting composition may have a poor thermal conductivity, and if the amount exceeds 12,000 parts by weight, the composition may have poor spreadability.

Component (C) contains component (C-1) and component (C-2) in an amount of preferably 50 to 90% by weight, more preferably 50 to 80% by weight, still more preferably 50 to 70% by weight, relative to the total weight of component (C). If the amount of component (C-1) and component (C-2) is less than 50% by weight, the thermal conductivity may be low. If the amount of component (C-1) and component (C-2) exceeds 90% by weight, the composition may fail to be uniform.

In addition, the ratio of the amount of component (C-1) to the amount of component (C-2) is preferably 50:50 to 95:5, preferably 60:40 to 80:20, on a weight basis. If the ratio of the amount of component (C-1) is less than 50, the thermal conductivity may be low. If the ratio of the amount of component (C-1) is more than 95, the adhesive force may be low.

### [Component (D)]

Component (D) is an organohydrogenpolysiloxane. The organohydrogenpolysiloxane serves to form a crosslinked structure through an addition reaction of the SiH groups in the molecule with the aliphatic unsaturated hydrocarbon groups in the composition under the presence of a platinum group metal catalyst, to be described later. The organohydrogenpolysiloxane is represented by the general formula (2). 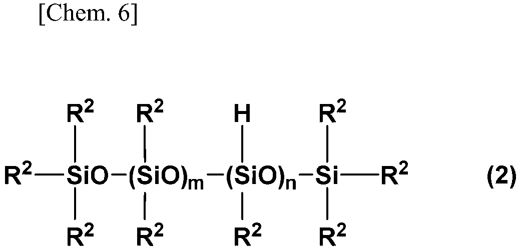 (wherein n and m are each a number larger than 0, satisfying 5.0 ≤ n + m ≤ 100 and n/(n + m) ≤ 0.5, and R² is each independently a C₁-C₆ alkyl group.)

It is essential that the organohydrogenpolysiloxane be free of SiH groups at terminal positions of the molecular chain. In the case where an organohydrogenpolysiloxane having SiH groups at terminal positions of the molecular chain is used, the storage stability of the silicone composition may be considerably low. Furthermore, n and m satisfy 5.0 ≤ n + m ≤ 100, preferably 10 ≤ n + m ≤ 80. If n + m is less than 5.0, the silicone composition may have a low physical quality, and if n + m is more than 100, the silicone composition may have poor spreadability. In addition, n and m satisfy n/(n + m) ≤ 0.5, preferably n/(n + m) ≤ 0.3. If n/(n + m) is more than 0.5, the silicone composition may have low adhesiveness. R² is each independently a C₁-C₆ alkyl group, and examples thereof include a methyl group, an ethyl group, a propyl group, an isopropyl group, a butyl group, a sec-butyl group, a tert-butyl group, a pentyl group, a hexyl group, and the like. The organohydrogenpolysiloxane may be used alone or in admixture of two or more.

The amount of component (D) is 1.0 to 8.0 parts by weight, preferably 1.2 to 7.0 parts by weight, per 100 parts by weight of component (A). If the amount of component (D) is less than 1.0 parts by weight, a cured product of the resulting composition may have poor and low hardness, and if the amount is more than 8.0 parts by weight, poorly the cured product of the composition may have high hardness.

### [Component (E)]

Component (E) is an organohydrogenpolysiloxane. The organohydrogenpolysiloxane serves to form a crosslinked structure through an addition reaction of the SiH groups in the molecule with the aliphatic unsaturated hydrocarbon groups in the composition under the presence of the platinum group metal catalyst, to be described later, and impart adhesiveness to the silicone composition. The organohydrogenpolysiloxane is represented by the general formula (3). 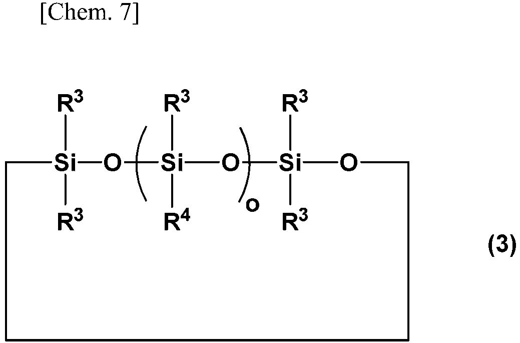 (wherein o is an integer of 1 to 8, R³ is each independently a hydrogen atom, a C₁-C₆ alkyl group, or R⁴, provided that two or three groups out of the groups represented by R³ are hydrogen atoms. R⁴ in the formula is a group selected from the group consisting of an epoxy group, an acryloyl group, a methacryloyl group, an ether group, and a trialkoxysilyl group, which is bonded to a silicon atom via a carbon atom or an oxygen atom.)

R³ in the formula is each independently a hydrogen atom, a C₁-C₆ alkyl group, or R⁴, provided that two or three groups out of the groups represented by R³ are hydrogen atoms. R⁴ in the formula is a group selected from the group consisting of an epoxy group, an acryloyl group, a methacryloyl group, an ether group, and a trialkoxysilyl group, which is bonded to a silicon atom via a carbon atom or an oxygen atom, and has an effect of imparting adhesiveness to the silicone composition. R³ is each independently a C₁-C₆ alkyl group, and examples thereof include a methyl group, an ethyl group, a propyl group, an isopropyl group, a butyl group, a sec-butyl group, a tert-butyl group, a pentyl group, a hexyl group, and the like. The organohydrogenpolysiloxane may be used alone or in admixture of two or more.

The amount of component (E) is 1.0 to 7.0 parts by weight, preferably 1.5 to 7.0 parts by weight, per 100 parts by weight of component (A). If the amount of component (D) is less than 1.0 parts by weight, the adhesive force of the resulting composition is low. If the amount is more than 7.0 parts by weight, poorly the cured product of the composition may have low hardness.

### [Component (F)]

Component (F) is a hydrolyzable organopolysiloxane for imparting wettability relative to the thermally conductive filler, and imparting adhesiveness to the silicone composition. The hydrolyzable organopolysiloxane is represented by the general formula (4). 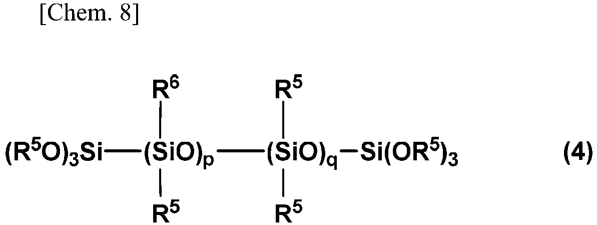 (wherein p and q are each a number larger than or equal to 1.0, satisfying 5.0 ≤ p + q ≤ 100, R⁵ is each independently a C₁-C₆ alkyl group, and R⁶ is a C₂-C₆ alkenyl group.)

p and q satisfy 5.0 ≤ p + q ≤ 100, preferably 10 ≤ p + q ≤ 60. If p + q is less than 5.0, serious oil bleeding derived from the silicone composition may be caused, degrading reliability. If p + q is more than 100, wettability relative to the filler may be insufficient.

R⁵ is each independently a C₁-C₆ alkyl group, and examples thereof include a methyl group, an ethyl group, a propyl group, an isopropyl group, a butyl group, a sec-butyl group, a tert-butyl group, a pentyl group, a hexyl group, and the like. R⁶ is a C₂-C₆ alkenyl group, and examples thereof include a vinyl group, an allyl group, a propenyl group, an isopropenyl group, a butenyl group, a hexenyl group, a cyclohexenyl group, and the like.

The amount of component (F) is 1 to 30 parts by weight, preferably 3 to 25 parts by weight, more preferably 5 to 20 parts by weight, per 100 parts by weight of component (A). If the amount of component (F) is below the lower limit, wettability and adhesiveness may be insufficient. If the amount of component (F) exceeds the lower limit, considerable bleeding from a cured product obtained from the composition of the invention may be caused.

### [Component (G)]

Component (G) is a platinum group metal catalyst, and functions to promote the above-described addition reaction. Any well-known material which can be used for the addition reaction may be employed as the platinum group metal catalyst. Examples thereof include platinum base, palladium base, and rhodium base catalysts. In particular, platinum or a platinum compound, which are relatively readily available, are preferred. Examples of the platinum base catalyst include elemental platinum, platinum black, chloroplatinic acid, a platinum-olefin complex, a platinum-alcohol complex, a platinum coordination compound, and the like. The platinum base catalyst may be used alone or in admixture of two or more.

The amount of component (G) is a catalytic amount, that is, an amount needed for promoting the addition reaction to cure the composition of the invention. In particular, the amount is preferably 0.1 to 500 ppm, more preferably 1 to 200 ppm relative to the total amount of the composition, on the basis of the weight of platinum-group metal atoms. If the amount of the catalyst is below the lower limit, the catalyst may fail to exert its effect. An amount of the catalyst exceeding the upper limit is not preferred as well because it does not increase the effect of the catalyst and thus is uneconomical.

### [Component (H)]

Component (H) is a reaction inhibitor for inhibiting progress of hydrosilylation at room temperature, which functions to extend the shelf life and the pot life. The reaction inhibitor may be selected from well-known reaction inhibitors used in addition curable silicone compositions. Examples of the reaction inhibitor include acetylene compounds, typically acetylene alcohols such as ethynylmethylcarbinol, 1-ethynyl-1-cyclohexanol, and 3,5-dimethyl-1-hexyn-3-ol; nitrogen compounds such as tributylamine, tetramethylethylene diamine, and benzotriazole; organophosphorus compounds such as triphenylphosphine; oxime compounds; and organic chloro-compounds.

The amount of component (H) is 0.05 to 5.0 parts by weight, preferably 0.1 to 1.0 parts by weight, per 100 parts by weight of component (A). If the amount of the reaction inhibitor is less than 0.05 parts by weight, satisfactory shelf life and pot life as desired may fail to be achieved, and if the amount exceeds 5.0 parts by weight, the silicone composition may have low curability. The inhibitor may be diluted with an organo(poly)siloxane, toluene, or the like to be improved in dispersibility in the silicone composition.

### [Other components]

The silicone composition of the invention may contain a non-reactive organo(poly)siloxane such as methylpolysiloxane for controlling the elastic modulus or viscosity of the composition. In addition, a well-known antioxidant such as 2,6-di-t-butyl-4-methylphenol may be contained as necessary for preventing degradation of the silicone composition. Furthermore, a dye, a pigment, a flame retardant, an anti-settling agent, a thixotropy improver, or the like may be blended as necessary.

A method of preparing the thermally conductive silicone composition of the invention is given below although the invention is not limited thereto. The method of preparing the thermally conductive silicone composition of the invention includes a step of preparing the silicone composition containing components (A) to (H) described above.

### [Step of preparing silicone composition]

The silicone composition of the invention may be prepared according to a conventional method of preparing a silicone grease composition, and the method is not particularly limited. For example, the silicone composition can be prepared by a method of mixing components (A) to (J) described above and optional other components with use of a mixer such as Trimix, Twin Mix, Planetary Mixer (all registered trademarks of mixers from Inoue Mfg., Inc.), Ultra Mixer (registered trademark of mixer from Mizuho Industrial Co., Ltd.), or Hivis Disper Mix (registered trademark of mixer from Tokushu Kika Kogyo Co., Ltd.). When components (C-1) to (C-3) are used as component (C), components (C-1) to (C-3) are preferably mixed in advance with component (A) and component (B) from the aspect of producing a uniform composition.

The silicone composition of the invention has an absolute viscosity at 25°C of preferably 3.0 to 800 Pa·s, more preferably 150 to 450 Pa·s. If the absolute viscosity is less than 3.0 Pa·s, workability may be low because of poor shape retention or the like. If the absolute viscosity is more than 800 Pa·s, workability may be low as well because of difficulty in ejection. The above absolute viscosity can be achieved by controlling the amounts of the above components to be compounded. The absolute viscosity herein is measured at 25°C by a Malcom viscometer (10 rpm by rotor A, shear rate: 6 [1/s]).

The silicone composition of the invention has a thermal conductivity at 25°C of preferably 4.0 W/m·°C or more, more preferably 5.0 W/m·°C or more, still more preferably 6.0 W/m·°C or more. The thermal conductivity herein is measured by TPA-501 from Kyoto Electronics Manufacturing Co., Ltd.

The thickness of the coating film of the silicone composition measured by the following measurement method is preferably 100 µm or less, more preferably 75 µm or less, still more preferably 65 µm or less. The silicone composition having the above property can, for example, form a thin coating film when applied between a heat generating member and a cooling member of a semiconductor device and, after the silicone composition is cured, a thin cured product layer can be obtained.

The method herein of measuring the thickness of the coating film of the silicone composition is as follows. With each composition sandwiched between two circular aluminum plates (diameter: 12.6 mm, thickness: 1 mm) so as to be 100 µm thick, a pressure of 0.1 MPa is applied thereto at 25°C for 60 minutes, thereby a test piece is prepared.

The thickness of the test piece is measured by a known micrometer and the thicknesses of the aluminum plates measured in advance are subtracted therefrom, thereby measuring the thickness of the composition.

### [Cured product]

The silicone composition of the invention can be suitably used for heat dissipation while interposed between a heat generating member and a cooling member of electronic devices such as LSIs and other devices to transmit heat from the heat generating member to the cooling member, and can be used similarly to a conventional thermally conductive silicone grease. For example, the silicone composition of the invention can be cured by heat generated by a heat generating member of an electronic device or the like. Alternatively, the silicone composition of the invention may be positively heated to be cured after application. In this manner, a semiconductor device having a cured product of the silicone composition of the invention interposed between a heat generating member and a cooling member. The curing conditions at the time of heat curing of the silicone composition of the invention is not particularly limited, and the curing is generally performed at 80 to 200°C, preferably 100 to 180°C, for 30 minutes to 4 hours, preferably 30 minutes to 2 hours.

From the aspect of increasing adhesiveness and heat dissipation ability, the thickness of the cured product layer of the silicone composition interposed between the heat generating member and the cooling member is preferably 100 µm or less, more preferably 75 µm or less, still more preferably 65 µm or less.

The thickness of the cured product layer can be controlled by controlling the thickness of the coating film of the silicone composition. In addition, the thickness of the coating film can be further reduced by pressing the heat generating member and the cooling member with the silicone composition interposed therebetween at predetermined temperature and pressure, with which the heat dissipation properties are expected to be further improved while good adhesiveness is maintained.

### [Tensile shear adhesive force]

The tensile shear adhesive force of the cured product of the silicone composition of the invention is preferably 0.05 to 3.0 MPa, and a method of measuring an adhesive force of 0.1 to 2.0 MPa is as described in the following Examples.

The silicone composition of the invention has a high thermal conductivity and good adhesiveness and can form a thin coating film, and therefore can be particularly suitably used as a heat dissipating grease for high-grade semiconductor devices and the like.

### EXAMPLES

The invention will be described in further detail below with reference to Examples and Comparative Examples, but the invention is not limited to the following Examples. The kinematic viscosities below were obtained by measurement at 25°C by an Ubbelohde-type Ostwald viscometer (Sibata Scientific Technology Ltd.).

### [Component (A)]

A-1: dimethylpolysiloxane which is capped with dimethylvinylsilyl groups at both ends and has a kinematic viscosity at 25°C of 600 mm²/s
A-2: dimethylpolysiloxane which is capped with dimethylvinylsilyl groups at both ends and has a kinematic viscosity at 25°C of 400 mm²/s

### [Component (B)]

B-1: polyorganosiloxane which is represented by the following average formula and has hydrolyzable groups

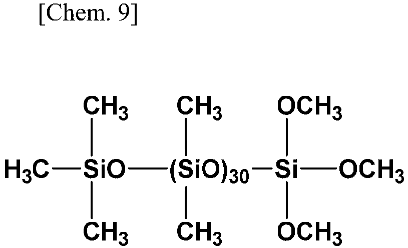

### [Component (C)]

C-1-1: aluminum nitride powder of a round shape having an average particle size of 19.6 µm (sieve residue on 200-mesh wire gauze: 0.02% by weight, comb residue on 325-mesh wire gauze: 0.9% by weight)
C-1-2: aluminum nitride powder of a round shape having an average particle size of 22.6 µm (sieve residue on 200-mesh wire gauze: 0.04% by weight, comb residue on 325-mesh wire gauze: 0.01% by weight)
C-1-3: aluminum nitride powder of a round shape having an average particle size of 15.6 µm (sieve residue on 200-mesh wire gauze: 0.01% by weight, comb residue on 325-mesh wire gauze: 0.70% by weight)
C-1-4: aluminum nitride powder of a round shape having an average particle size of 10.6 µm (sieve residue on 200-mesh wire gauze: 0.01% by weight, comb residue on 325-mesh wire gauze: 0.01% by weight)
C-1-5: aluminum nitride powder of a round shape having an average particle size of 20.9 µm (sieve residue on 200-mesh wire gauze: 1.02% by weight, comb residue on 325-mesh wire gauze: 8.76% by weight)
C-2-1: aluminum nitride powder of a round shape having an average particle size of 6.6 µm (sieve residue on 200-mesh wire gauze: 0.01% by weight, comb residue on 325-mesh wire gauze: 0.01% by weight)
C-2-2: aluminum nitride powder of a round shape having an average particle size of 2.6 µm (sieve residue on 200-mesh wire gauze: 0.01% by weight, comb residue on 325-mesh wire gauze: 0.01% by weight)
C-2-3: aluminum oxide powder of a spherical shape having an average particle size of 3.6 µm (sieve residue on 200-mesh wire gauze: 0.01% by weight, comb residue on 325-mesh wire gauze: 0.01% by weight)
C-3-1: zinc oxide powder having an average particle size of 0.4 µm
C-3-2: zinc oxide powder having an average particle size of 0.9 µm
C-3-3: aluminum nitride powder having an average particle size of 0.7 µm
C-3-4: aluminum oxide powder having an average particle size of 0.9 µm

### [Component (D)]

D-1: organohydrogenpolysiloxane represented by the following formula 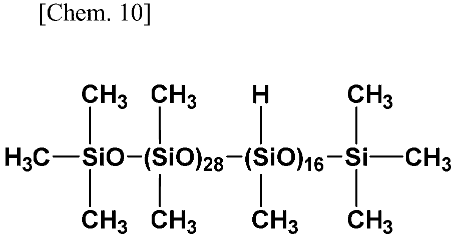
D-2: organohydrogenpolysiloxane represented by the following formula 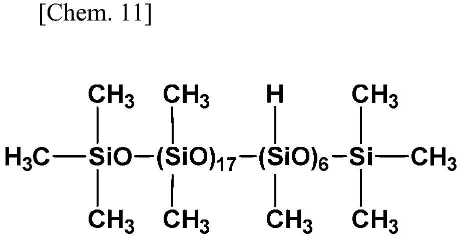
d-3: organohydrogenpolysiloxane (comparative product) represented by the following formula

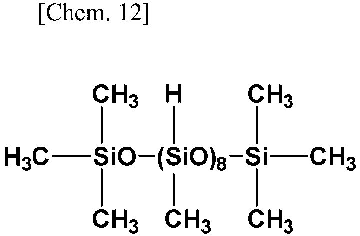

### [Component (E)]

E-1: organohydrogenpolysiloxane represented by the following formula 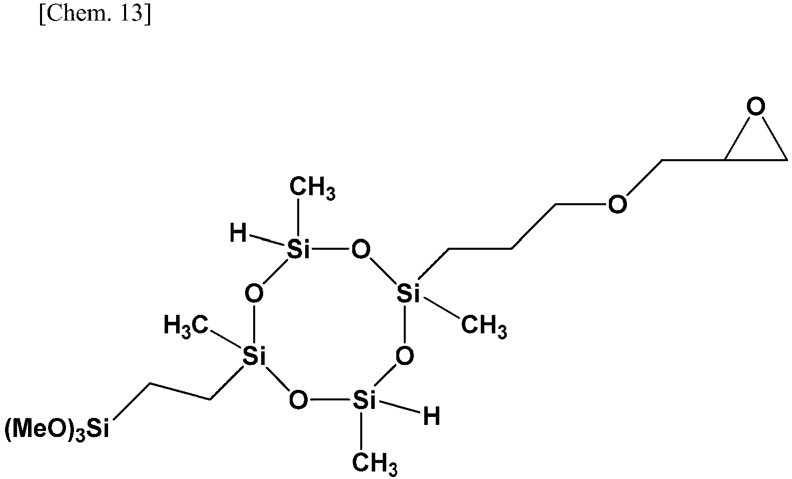
E-2: organohydrogenpolysiloxane represented by the following formula

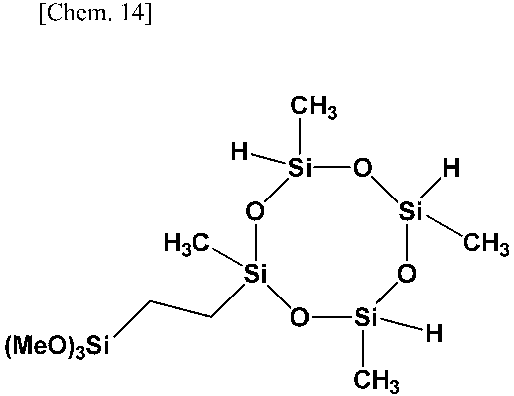

### [Component (F)]

F-1: hydrolyzable organopolysiloxane represented by the following formula 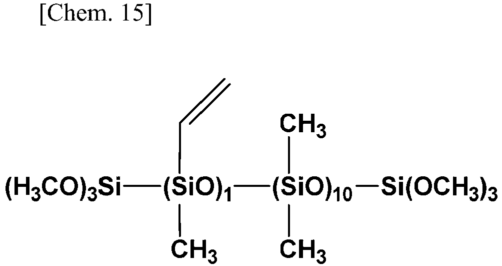
F-2: hydrolyzable organopolysiloxane represented by the following formula

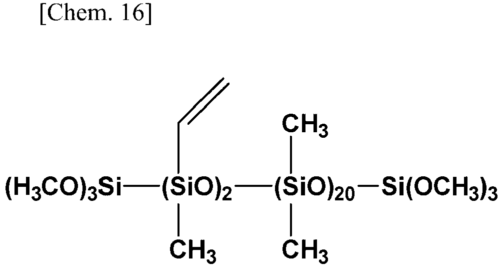

### [Component (G)]

G-1: solution of platinum-divinyltetramethyldisiloxane complex in dimethylpolysiloxane which is the same as the above A-1 (Pt content: 1 wt%)

### [Component (H)]

H-1: compound represented by the following formula

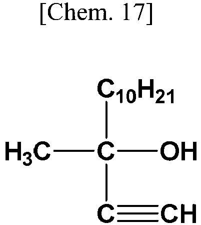

### [Examples 1 to 24 and Comparative Examples 1 to 6]

### (1) Preparation of silicone composition

Silicone compositions were prepared by compounding components (A) to (H) in accordance with the amounts shown in the following Tables 1 to 4 by the following method. Note that the weight of component (G) in Table 1 corresponds to the weight of the solution of the platinum-divinyltetramethyldisiloxane complex in dimethylpolysiloxane (Pt content: 1 wt%).

Components (A), (B), (C), and (F) were added to 5 L Planetary Mixer (Inoue Mfg., Inc.), and mixed at 170°C for 1 hour. The mixture was cooled to room temperature, and components (D), (E), (G), and (H) were added thereto and the mixture was mixed to be uniform, thereby preparing a silicone composition.

Each composition obtained by the above method was measured to determine the viscosity, thermal conductivity, elongation at break, and adhesion strength according to the following method. The results are shown in Tables 1 and 2.

### [Viscosity]

The absolute viscosity of each composition was measured at 25°C by a Malcom viscometer (type PC-1T).

### [Thermal conductivity]

Each composition was cured by heating at 125°C for 60 minutes to prepare a sheet 6 mm thick, and the thermal conductivity thereof was measured by TPS-2500 from Kyoto Electronics Manufacturing Co., Ltd.

### [Measurement of thickness]

Each composition was sandwiched between two circular aluminum plates (diameter: 12.6 mm, thickness: 1 mm) so as to have a thickness of 100 µm, and a pressure of 0.1 MPa was applied thereto at 25°C for 60 minutes, thereby preparing a test piece.

The thickness of the test piece was measured by a micrometer (Mitutoyo Corporation), and the thicknesses of the aluminum plates measured in advance were subtracted therefrom, thereby measuring the thickness of the composition.

### [Measurement of tensile shear adhesive force]

Each composition was sandwiched between two aluminum (JIS H 4000 A1050P) plates 1.0 mm thick so as to have a thickness of 2.0 mm and a bonded area of 25 mm × 10 mm, and heated at 125°C for 1 hour so that the composition was cured, thereby preparing an adhesion test piece. The tensile shear adhesive force of the test piece was measured in accordance with JIS K 6850.

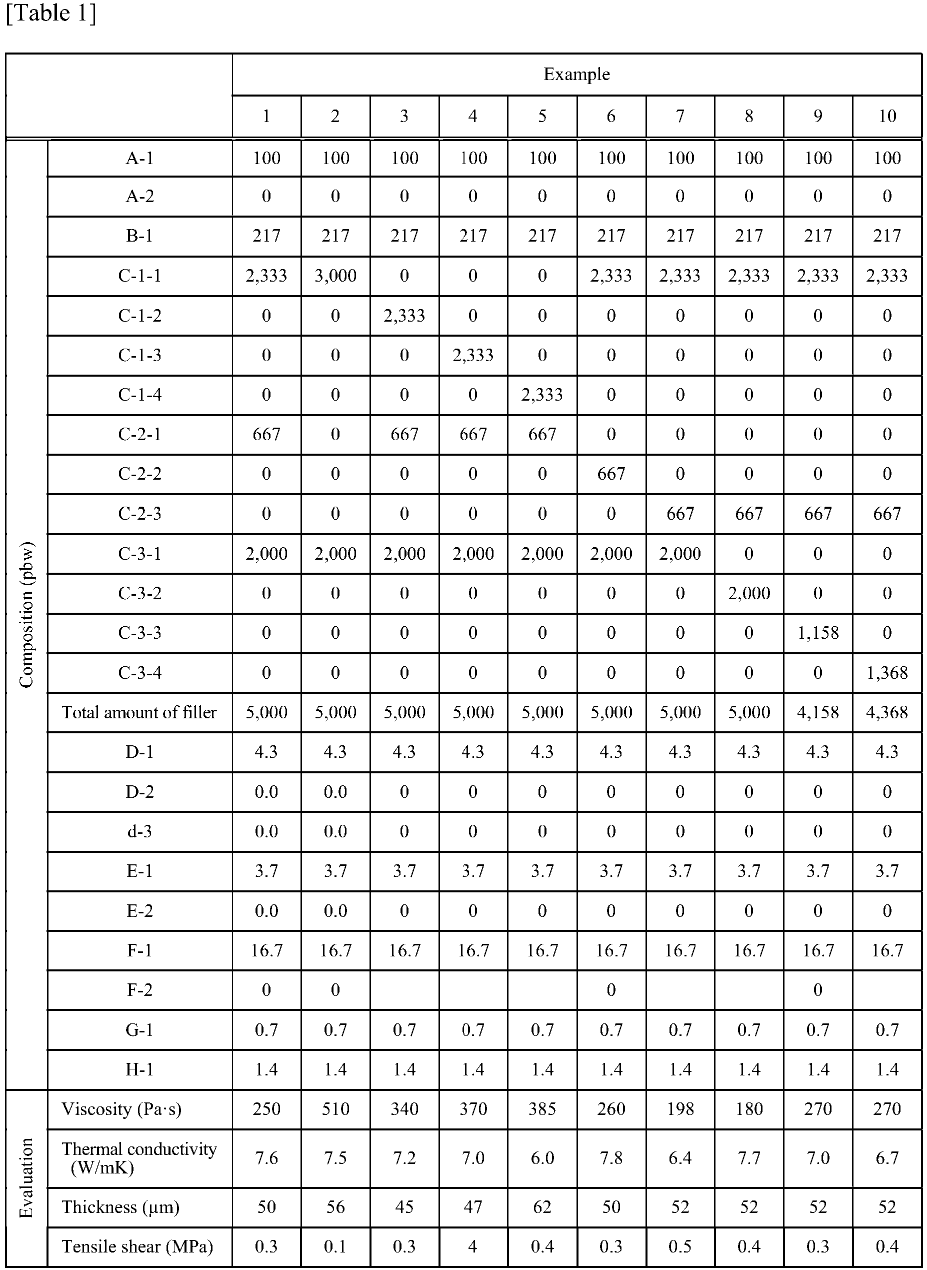

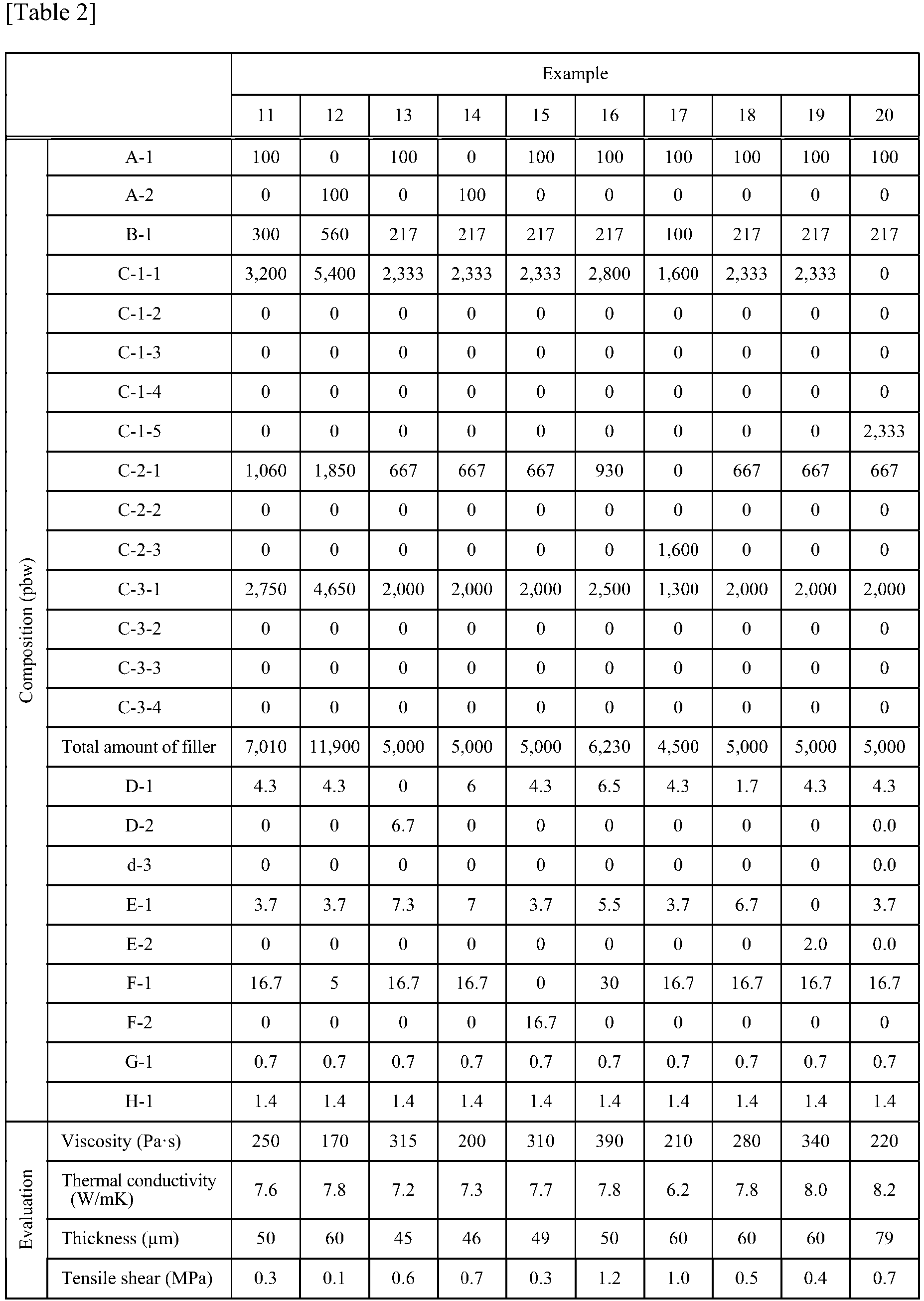

**[Table 3]**

| | | Example | | | |
|---|---|---|---|---|---|
| | | 21 | 22 | 23 | 24 |
| Composition (pbw) | A-1 | 100 | 100 | 100 | 100 |
| | A-2 | 0 | 0 | 0 | 0 |
| | B-1 | 217 | 217 | 217 | 217 |
| | C-1-1 | 1,500 | 2,850 | 1,875 | 0 |
| | C-1-2 | 0 | 0 | 0 | 0 |
| | C-1-3 | 0 | 0 | 0 | 3,000 |
| | C-1-4 | 0 | 0 | 0 | 0 |
| | C-2-1 | 1,500 | 150 | 625 | 1,000 |
| | C-2-2 | 0 | 0 | 0 | 0 |
| | C-2-3 | 0 | 0 | 0 | 0 |
| | C-3-1 | 2,000 | 2,000 | 2,500 | 1,000 |
| | C-3-2 | 0 | 0 | 0 | 0 |
| | C-3-3 | 0 | 0 | 0 | 0 |
| | C-3-4 | 0 | 0 | 0 | 0 |
| | Total amount of filler | 5,000 | 5,000 | 5,000 | 5,000 |
| | D-1 | 4.3 | 4.3 | 4.3 | 4.3 |
| | D-2 | 0.0 | 0.0 | 0 | 0 |
| | d-3 | 0.0 | 0.0 | 0 | 0 |
| | E-1 | 3.7 | 3.7 | 3.7 | 3.7 |
| | E-2 | 0.0 | 0.0 | 0 | 0 |
| | F-1 | 16.7 | 16.7 | 16.7 | 16.7 |
| | F-2 | 0 | 0 | 0 | 0 |
| | G-1 | 0.7 | 0.7 | 0.7 | 0.7 |
| | H-1 | 1.4 | 1.4 | 1.4 | 1.4 |
| Evaluation | Viscosity (Pa·s) | 210 | 510 | 470 | 390 |
| | Thermal conductivity (W/mK) | 6.8 | 7.7 | 6.6 | 7.6 |
| | Thickness (µm) | 50 | 56 | 56 | 47 |
| | Tensile shear (MPa) | 1.6 | 0.1 | 1.5 | 0.2 |

**[Table 4]**

| | | Comparative Example | | | | | |
|---|---|---|---|---|---|---|---|
| | | 1 | 2 | 3 | 4 | 5 | 6 |
| Composition (pbw) | A-1 | 100 | 0 | 100 | 100 | 100 | 100 |
| | A-2 | 0 | 100 | 0 | 0 | 0 | 0 |
| | B-1 | 150 | 650 | 300 | 600 | 217 | 217 |
| | C-1-1 | 1,250 | 5,400 | 3,200 | 5,625 | 2,333 | 2,333 |
| | C-1-2 | 0 | 0 | 0 | 0 | 0 | 0 |
| | C-1-3 | 0 | 0 | 0 | 0 | 0 | 0 |
| | C-1-4 | 0 | 0 | 0 | 0 | 0 | 0 |
| | C-2-1 | 1,250 | 1,850 | 1,060 | 1,875 | 667 | 667 |
| | C-2-2 | 0 | 0 | 0 | 0 | 0 | 0 |
| | C-2-3 | 0 | 0 | 0 | 0 | 0 | 0 |
| | C-3-1 | 1,040 | 4,650 | 2,750 | 5,400 | 2,000 | 2,000 |
| | C-3-2 | 0 | | 0 | | 0 | 0 |
| | C-3-3 | 0 | 0 | 0 | 0 | 0 | 0 |
| | C-3-4 | 0 | 0 | 0 | 0 | 0 | 0 |
| | Total amount of filler | 3,540 | 11,900 | 7,010 | 12,900 | 5,000 | 5,000 |
| | D-1 | 4.3 | 4.3 | 4.3 | 4.3 | 4 | 8.0 |
| | D-2 | 0 | 0 | 0 | 0 | 0 | 0 |
| | d-3 | 0 | 0 | 0 | 0 | 2.3 | 0 |
| | E-1 | 3.7 | 3.7 | 3.7 | 3.7 | 3.7 | 0 |
| | E-2 | 0 | 0 | 0 | 0 | 0 | 0 |
| | F-1 | 16.7 | 5 | 0 | 16.7 | 16.7 | 16.7 |
| | F-2 | 0 | 0 | 0 | 0 | 0 | 0 |
| | G-1 | 0.7 | 0.7 | 0.7 | 0.7 | 0.7 | 0.7 |
| | H-1 | 1.4 | 1.4 | 1.4 | 1.4 | 1.4 | 1.4 |
| Evaluation | Viscosity (Pa·s) | 89 | 110 | 270 | Not uniform | 250 | 240 |
| | Thermal conductivity (W/mK) | 3.8 | 7 | 8 | | Not cured | 7.6 |
| | Thickness (µm) | 60 | 60 | 45 | | 50 | 50 |
| | Tensile shear (MPa) | 1.8 | 0.02 | 0.04 | | Not cured | 0.01 |

According to the results shown in Tables 1 to 4, the silicone composition had a lower viscosity, a higher thermal conductivity, and a greater adhesive force in Examples 1 to 24, which satisfy the requirements of the invention, than in Comparative Examples 1 to 6. On the other hand, the thermal conductivity was low in Comparative Example 1 in which the amount of component (C) was as small as 3,540 parts by weight relative to 100 parts by weight of component (A). The adhesive force was low in Comparative Example 2 in which the amount of component (B) was as large as 650 parts by weight relative to 100 parts by weight of component (A) and in Comparative Example 3 in which component (F) was not contained. The composition was not uniform in Comparative Example 4 in which the amount of component (C) was large. The composition did not cure in Comparative Example 5 in which n/(n + m) > 0.5 held regarding component (D). The adhesive force was low in Comparative Example 6 in which component (E) was not contained.

Therefore, it was confirmed that the silicone composition of the invention had good adhesiveness when used to cause a semiconductor chip and a heat spreader to solidly adhere to each other, even when a large amount of heat conductive filler was contained.

## Claims

1. A silicone composition comprising components (A) to (D):
(A) an organopolysiloxane having at least two aliphatic unsaturated hydrocarbon groups per molecule and a kinematic viscosity at 25°C of 60 to 100,000 mm²/s in an amount of 100 parts by weight;
(B) a hydrolyzable organopolysiloxane represented by the general formula (1) in an amount of 100 to 600 parts by weight: 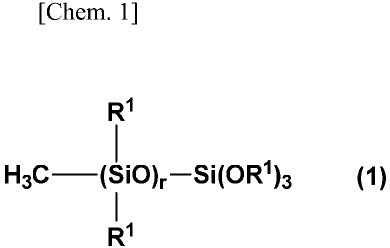 wherein R¹ is each independently a C₁-C₆ alkyl group and r is an integer of 5 to 100;
(C) at least one heat conductive filler selected from the group consisting of metal oxides and metal nitrides in an amount of 4,001 to 12,000 parts by weight;
(D) an organohydrogenpolysiloxane represented by the general formula (2) in an amount of 1.0 to 8.0 parts by weight: 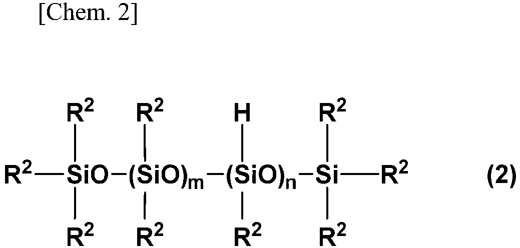 wherein n and m are each a number larger than 0 satisfying 5.0 ≤ n + m ≤ 100 and n/(n + m) ≤ 0.5, and R² is each independently a C₁-C₆ alkyl group;
(E) an organohydrogenpolysiloxane represented by the general formula (3) in an amount of 1.0 to 7.0 parts by weight: 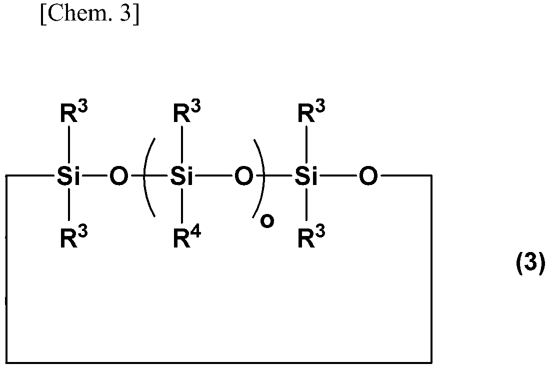 wherein o is an integer of 1 to 8; R³ is each independently a hydrogen atom, a C₁-C₆ alkyl group, or R⁴, provided that two or three groups out of the groups represented by R³ are hydrogen atoms; and R⁴ is a group selected from the group consisting of an epoxy group, an acryloyl group, a methacryloyl group, an ether group, and a trialkoxysilyl group, which is bonded to a silicon atom via a carbon atom or an oxygen atom;
(F) a hydrolyzable organopolysiloxane represented by the general formula (4) in an amount of 1 to 30 parts by weight: 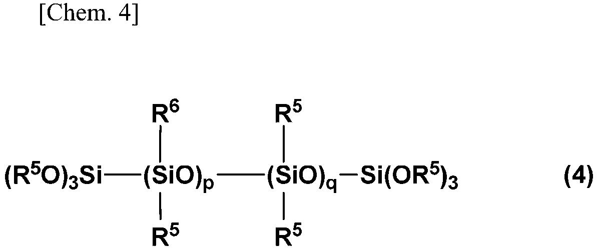 wherein p and q are each a number larger than or equal to 1.0 satisfying 5.0 ≤ p + q ≤ 100, R⁵ is each independently a C₁-C₆ alkyl group, and R⁶ is a C₂-C₆ alkenyl group;
(G) a platinum group metal catalyst in a catalytic amount; and
(H) a reaction inhibitor in an amount of 0.05 to 5.0 parts by weight.

2. The silicone composition of claim 1, wherein component (C) contains components (C-1) to (C-3):
(C-1) aluminum nitride particles that have an average particle size of 10 µm or more and less than 30 µm and yield a residue in an amount of less than 1.0% by weight after being sieved through a 200-mesh wire gauze;
(C-2) a metal oxide or a metal nitride having an average particle size of 1 µm or more and less than 10 µm; and
(C-3) a metal oxide or a metal nitride having an average particle size of 0.1 µm or more and less than 1 µm.

3. The silicone composition of claim 1, wherein a cured product of the silicone composition has a thermal conductivity of 4.0 W/m·K or more.

4. A semiconductor device comprising:
a cured product of a silicone composition interposed between a heat generating member and a cooling member, wherein
a layer of the cured product is composed of a cured product of the silicone composition of any one of claims 1 to 3 and has a thickness of 100 µm or less.

5. A method of preparing the silicone composition of claim 2, the method comprising:
a step of mixing components (C-1) to (C-3) with component (A) and component (B) in advance.
